Europäisches Patentamt

European Patent Office

Office européen des brevets

(19)

(11) Numéro de publication: **0 205 385**
**B1**

(12)

# FASCICULE DE BREVET EUROPEEN

(45) Date de publication du fascicule du brevet:
**20.12.89**

(51) Int. Cl.⁴: **H 05 K 7/08, G 09 B 23/18**

(21) Numéro de dépôt: **86401236.4**

(22) Date de dépôt: **09.06.86**

---

(54) Procédé de fabrication d'un panneau de montage d'éléments amovibles, en particulier pour jouet pédagogique.

---

(30) Priorité: **10.06.85 FR 8508732**

(43) Date de publication de la demande:
**17.12.86 Bulletin 86/51**

(45) Mention de la délivrance du brevet:
**20.12.89 Bulletin 89/51**

(84) Etats contractants désignés:
**AT BE CH DE FR GB IT LI LU NL SE**

(56) Documents cités:
**EP-A- 0 069 212**
**WO-A-83/03318**
**DE-A- 2 804 587**

(73) Titulaire: **Thévenin, Gilles, 14d, rue René Coty,**
**F-71100 Chalon-sur-Saône (FR)**

(72) Inventeur: **Thévenin, Gilles, 14d, rue René Coty,**
**75008 Paris (FR)**
Inventeur: **Ducroux, Maurice, Fissey-Moroges,**
**71390 BUXY (FR)**

(74) Mandataire: **Bruder, Michel, 10 rue de la Pépinière,**
**F-75008 Paris (FR)**

## Description

La présente invention concerne un procédé de fabrication d'un panneau de montage d'éléments amovibles, en particulier pour jouets pédagogiques permettant d'effectuer des montages électroniques simples «en l'air», du type montages «Tour Eiffel».

Dans les panneaux de montage usuels on utilise un support en matière isolante sur lequel sont disposés des points de contact conducteurs ou un support en matière isolante percé de trous dans lesquels sont moulés des bouchons de matière souple conductrice ainsi qu'il est décrit dans le brevet FR-A-2 363 967. Des panneaux de montage du genre considéré sont constitués de ressorts de contact montés entre une plaque supérieure et une plaque inférieure, et accessibles, pour le raccordement, par des trous percés dans la plaque supérieure. Un autre panneau de montage connu est constitué, comme décrit dans le brevet FR-A-2 446 544, par une rainure annulaire offrant une paroi interne et une paroi externe et par un élément élastique disposé dans la rainure annulaire, étant bien entendu que les parois interne et externe peuvent être électriquement conductrices et l'élément élastique isolant ou vice versa.

On connaît également, ainsi qu'il est décrit dans le brevet EP-A-0 069 212, un panneau de connexion en matière isolante, percé de trous débouchant dans une de ses faces et dans lesquels sont engagés des paquets de fils conducteurs parallèles s'étendant au ras de la face du panneau. Les extrémités internes des fils d'un même paquet sont noyées dans un socle de matériau conducteur auquel est raccordé un conducteur électrique réalisé habituellement sous la forme d'un tracé de circuit imprimé.

Un panneau de montage du type précité est, à l'évidence, de fabrication difficile, nécessitant l'emploi de plusieurs machines et par là même il est d'un prix de revient onéreux.

La présente invention vise à remédier à ces inconvénients en procurant un moyen de fabrication particulièrement simple, ce qui a pour conséquence un prix de revient relativement faible. De plus ce genre de panneau de montage permet de conserver un bon contact après de nombreuses manipulations.

A cet effet ce procédé de fabrication d'un panneau de montage d'éléments amovibles, en particulier pour jouet pédagogique, permettant d'effectuer des montages électroniques simples «en l'air» du type montages «Tour Eiffel», à partir de composants élémentaires, comportant un support percé de trous débouchant dans au moins une face du support et contenant respectivement des touffes de poils parallèles les uns aux autres constituant ainsi des plots pouvant être utilisés pour y enfoncer longitudinalement les branches des composants devant être montés sur le panneau, est caractérisé en ce qu'on engage les touffes de poils parallèles dans les trous respectifs du support en laissant une partie des poils s'étendre à l'extérieur à la façon des poils d'une brosse, et on coupe ensuite les touffes de poils au ras de la face du support dans laquelle débouchent les trous.

Les poils utilisés pour constituer les «plots» peuvent être métalliques ou en matière synthétique conductrice de l'électricité ou bien encore en matière isolante lorsque la fonction de connexion électrique ne doit pas être assumée. Les «plots» peuvent être avantageusement constitués par des touffes de poils bourrées dans les trous de manière que chaque poil forme une sorte de U dans le trou, les poils en U de chaque touffe étant fixés dans le trou au moyen d'une pointe ou agrafe enfoncée dans le fond du trou.

Les trous percés dans le panneau de montage pour loger les touffes de poils peuvent être des trous borgnes ou bien encore ils peuvent traverser le panneau de part en part.

Suivant une caractéristique complémentaire de l'invention les poils constituant les plots sont des brins ondulés dans le sens longitudinal.

Les applications du panneau de montage suivant l'invention sont nombreuses et variées. On peut citer, par exemple, les montages électroniques simples «en l'air» du type montages «Tour Eiffel», ou encore les créations fondées sur du fil de fer (ou autre matériau) utilisant la même technique que les fils de connexion des composants életroniques, par exemple la présentation d'objets sur berceau fil de fer, des figures filiformes, etc.

On décrira ci-après, à titre d'exemples non limitatifs, diverses formes d'exécution de la présente invention, en référence au dessin annexé sur lequel:

la figure 1 est une vue en coupe d'un panneau de montage obtenu par le procédé suivant l'invention, perpendiculairement à la surface de ce panneau;

la figure 2 est une vue en perspective du panneau après la mise en place des touffes de poils et avant arasement de ces touffes;

la figure 3 est une vue en perspective du panneau après arasement des touffes de poils;

la figure 4 est une vue en perspective du panneau de montage supportant un circuit électrique ou un montage filiforme;

la figure 5 est une vue en coupe axiale d'un «plot» constitué par des brins ondulés;

la figure 6 est une vue en coupe d'une variante d'exécution.

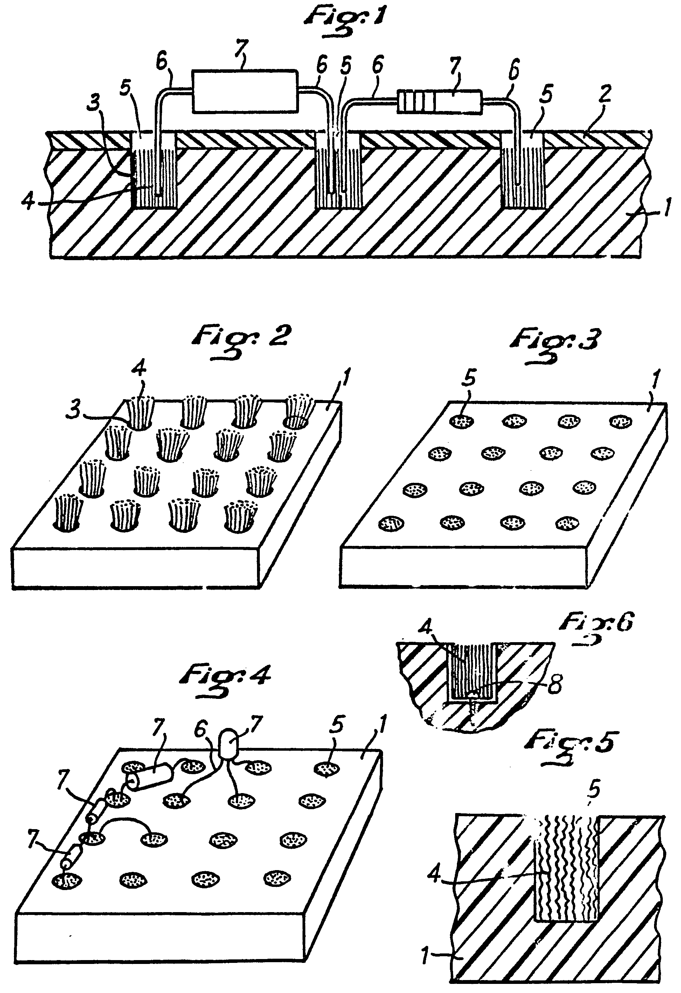

La figure 1 représente un panneau de montage supportant deux composants électroniques et qui se compose essentiellement d'un support 1 en matière électriquement isolante recouvert ou non par un cache 2 en matière plastique. Le support isolant est percé de trous 3 de préférence borgnes, qui débouchent dans sa face supérieure. Dans ces trous borgnes sont respectivement logées des touffes de poils 4 métalliques ou synthétiques conducteurs ou au contraire isolants, formant des plots 5, chaque plot individuel 5 étant totalement isolé des autres plots 5. Dans certains plots 5 sont insérés, suivant le montage que l'on désire réaliser, des fils de liaison 6 avec des composants életroniques tels que les éléments 7. Les fils de liaison 6, issus des composants 7, peuvent avoir le même diamètre ou des diamètres différents. Dans tous les cas la connexion électrique entre deux fils de liaison engagés dans un même plot 5 est assurée dans les meilleures conditions, du fait de l'élasticité transversale relative des poils de chaque touffe 4.

Le procédé de fabrication du panneau suivant l'invention consiste à partir d'une plaque isolante constituant le support isolant 1, à percer, dans cette plaque les trous 3 et à engager dans chaque trou une touffe de poils 4 s'étendant hors du trou (figure 2) comme sont fixés les poils d'une brosse dans un support par exemple en bois.

Ensuite on coupe les poils 4 au ras de la face supérieure de la plaque support 1 pour obtenir un panneau prêt à l'emploi comme il est illustré sur la figure 3. Sur cette figure on voit les plots 5 formés dans la plaque support 1 après arasement des touffes de poils au ras du support.

Dans la forme d'exécution de l'invention représentée sur la figure 4 est montrée une application du panneau de montage sivant l'invention. Le support 1 dans lequel ont été logés les plots 5 de la manière décrite en référence aux figures 2 et 3, supporte des composants élémentaires 7 insérés dans les plots 5 par l'intermédiaire de fils de liaison 6.

Dans la variante d'exécution de l'invention représentée sur la figure 5 les touffes de poils 4 formant les plots 5 sont constituées par des brins ondulés.

Suivant une variante d'exécution de l'invention représentée sur la figure 6 les plots 5 peuvent être avantageusement constituées par des touffes de poils bourrées dans les trous 3 de manière que chaque poil 4 forme une sorte de U dans le trou, les poils en U de chaque touffe étant fixés dans le trou au moyen d'une pointe ou agrafe 8 enfoncée dans le fond du trou.

**Revendications**

1. Procédé de fabrication d'un panneau de montage d'éléments amovibles, en particulier pour jouet pédagogique, permettant d'effectuer des montages électroniques simples en l'air, à partir de composants élémentaires, le panneau de montage comportant un support (1) percé de trous (3) débouchant dans au moins une face du support et contenant respectivement des touffes de poils (4) parallèles les uns aux autres constituant ainsi des plots (5) pouvant être utilisés pour y enfoncer longitudinalement les branches de composants devant être montés sur le panneau, caractérisé en ce qu'on engage les touffes de poils (4) parallèles dans les trous respectifs (3) du support (1) en laissant une partie des poils (4) s'étendre à l'extérieur à la façon des poils d'une brosse, et on coupe ensuite les touffes de poils (4) sur ras de la face du support (1) dans laquelle débouchent les trous (3).

2. Procédé suivant la revendication 1 caractérisé en ce qu'on enfonce dans chaque trou (3) des poils (4) constitués par des brins ondulés dans le sens longitudinal.

3. Procédé suivant l'une quelconque des revendications précédentes caractérisé en ce qu'on enfonce, dans chaque trous (3), des touffes de poils (4) bourrées dans les trous de manière que chaque poil forme une sorte de U dans le trou, et on fixe les poils en U de chaque touffe dans le trou au moyen d'une pointe (8) enfoncée dans le fond du trou.

**Patentansprüche**

1. Verfahren zur Herstellung einer Platte zum Aufbau von abnehmbaren Schaltungen, insbesondere für ein pädagogisches Spiel, die es gestattet, einfache elektronische, freiliegende Schaltungen ausgehend von Bauelementen herzustellen, wobei die Platte einen Träger (1) umfaßt, der mit an zumindest einer seiner Oberflächen ausmündenden Löchern(3) versehen ist, die jeweils Büschel von zueinander parallelen Borsten (4) enthalten und so Kontakte (5) bilden, die dazu benutzt werden können, in sie in Längsrichtung die Anschlüsse der auf der Platte anzuordnenden Bauelemente einzustecken, dadurch gekennzeichnet, daß man die Büschel aus parallelen Borsten (4) derart in die zugeordneten Löcher (3) des Trägers (1) einbringt, daß sich ein Abschnitt der Borsten (4) bürstenartig nach außen erstreckt, und daß man dann die Büschel aus Borsten(4) bündig mit der Oberfläche des Trägers (1) abschneidet, in der die Löcher (3) ausmünden.

2. Verfahren nach Anspruch 1, dadurch gekennzeichnet, daß man in jedes Loch (3) Borsten (4) einsetzt, die aus in Längsrichtung gewellten Fasern bestehen.

3. Verfahren nach einem der vorhergehenden Ansprüche, dadurch gekennzeichnet, daß man in jedes Loch (3) Büschel aus Borsten (4) einsetzt, die in den Löchern so angeordnet sind, daß jede Borste innerhalb des Lochs eine Art U-Form annimmt, und daß die U-förmigen Borsten eines jeden Büschels mittels eines in den Lochboden eingreifenden Befestigungsstifts befestigt sind.

**Claims**

1. Method of fabricating a mounting panel for removable elements, in particular for educational toys, for effecting simple «in the air» electronic assemblies type, from elementary components, the mounting panel comprising a support (1) pierced with holes (3) opening into at least one face of the support and containing respectively tufts of hairs (4) parallel to each other thus forming studs (5) which may be used for fixing longitudinally therein the legs of components to be mounted on the panel, characterized in that, the tufts of parallel hairs (4) are engaged in the respective holes (3) of the support (1) while leaving a part of the hairs (4) extending outwardly in the manner of the hairs of a brush and, then the tufts of hairs (4) are cut flush with the face of the support (1) in which the holes (3) open out.

2. Method as claimed in claim 1, characterized in that hairs formed by strands waved in the longitudinal direction are driven into each hole.

3. Method as claimed in one of the preceeding claims, characterized in that in each hole (3) tufts of hairs (4) are packed so that each hair forms a sort of U in the hole, and the U shaped hairs of each tuft are fixed in the hole by means of a nail (8) driven into the bottom of the hole.

*Fig: 1*

*Fig: 2*

*Fig: 3*

*Fig: 4*

*Fig: 6*

*Fig: 5*